# EUROPEAN PATENT APPLICATION

(11) **EP 3 179 519 A1**
(43) Date of publication of application: **14.06.2017**
(21) Application number: 16182350.5
(22) Date of filing: 02.08.2016
(51) Int. Cl.: H01L 29/812, H01L 29/41

(54) **SEMICONDUCTOR DEVICE**

(30) Priority: 08.12.2015 JP 2015239555
(71) Applicant: Kabushiki Kaisha Toshiba, Minato-ku, Tokyo (JP)
(72) Inventor: YOSHIDA, Shigeki, Tokyo (JP)
(74) Representative: Hoffmann Eitle

(57) **Abstract**

A stable high-frequency amplification characteristic with a high power is obtained by providing a source field plate electrode (17) in an area of a drain electrode side of a gate electrode (14) and connecting the source field plate electrode to a source electrode (13) with a fine wiring layer. In addition, a stress-absorbing layer (16) is stacked on an upper surface of an insulator film (15) just above the gate electrode, and a source field plate electrode is formed above the gate electrode to interpose the stress-absorbing layer, so that a stress is absorbed by a source field plate electrode side, and a mechanical damage to the gate electrode and peripheral portions thereof is suppressed.

## Description

### FIELD

Embodiments described herein relate generally to a semiconductor device, such as a field effect transistor (FET).

### BACKGROUND

There has been known a source field plate electrode where a field plate electrode is provided between a drain electrode and a gate electrode of a field effect transistor (FET) and the electrode is connected to a source electrode. In the source field plate electrode, since a breakdown voltage of the FET can be improved by alleviating field concentration in the vicinity of the gate electrode, the source field plate electrode can be applied to an FET for amplification or the like which is configured by using a semiconductor material such as gallium nitride (GaN) or gallium arsenide (GaAs) and is operated in a microwave band or a millimeter-wave band, and thus, high power can be obtained in such a frequency band.

In addition, in order to configure a high-frequency amplification device having a stable gain in the microwave band or a millimeter-wave band, particularly, a structure where parasitic capacitance Cgs between the gate electrode and the source electrode is reduced is preferred.

### BRIEF DESCRIPTION OF DRAWINGS

Fig. 1 is a top view illustrating a model of an example of a configuration of an upper surface of a semiconductor device according to an embodiment of the present invention.
Fig. 2 is a cross-sectional view illustrating a model of a cross-sectional structure of the semiconductor device illustrated in Fig. 1.
Fig. 3 is cross-sectional view illustrating a model of a first example of a change of a stress-absorbing layer 16 in a stress-absorbing period.
Fig. 4 is cross-sectional view illustrating a model of a second example of a change of a stress-absorbing layer 16 in a stress-absorbing period.

### DETAILED DESCRIPTION

According to one embodiment, there is provided a semiconductor device including: a semiconductor substrate; a drain electrode and a source electrode being formed to be separated from each other on the semiconductor substrate; a gate electrode being formed between the drain electrode and the source electrode; an insulator film covering the drain electrode, the source electrode, the gate electrode, and at least a portion of surfaces of the semiconductor substrate between these electrodes; a stress-absorbing layer being stacked on the insulator film covering an upper surface of the gate electrode in a shape corresponding to a shape of the upper surface of the gate electrode; and a source field plate electrode being formed on the insulator film between the gate electrode and the drain electrode to extend from an area corresponding to the drain electrode side of the gate electrode underlying the stress-absorbing layer toward the drain electrode to cover the drain electrode side on an upper surface of the stress-absorbing layer and being electrically connected to the source electrode with a wiring layer, wherein the stress-absorbing layer absorbs stress exerted by the source field plate electrode in a length direction of the gate electrode.

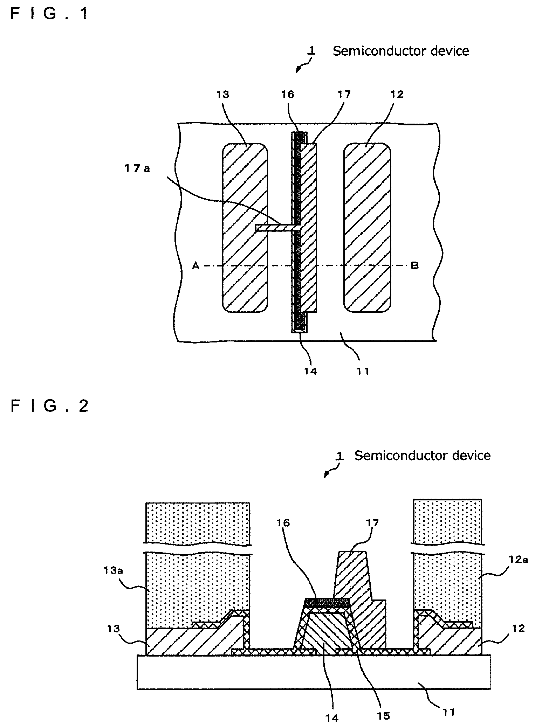

Hereinafter, the best mode for embodying a semiconductor device according to an embodiment of the present invention will be described with reference to Figs. 1 to 4.

Fig. 1 is a top view illustrating a model of an example of a configuration of an upper surface of a semiconductor device according to an embodiment of the present invention. Fig. 2 is a cross-sectional view illustrating a model of a cross-sectional structure of the semiconductor device taken along line A-B of Fig. 1. As illustrated in Figs. 1 and 2, the semiconductor device 1 is configured to include a drain electrode 12, a source electrode 13, a gate electrode 14, an insulator film 15, a stress-absorbing layer 16, and a source field plate electrode 17 on a semiconductor substrate 11 as a base. In addition, in Fig. 1, for avoiding complication of the drawings, a drain pad electrode 12a, a source pad electrode 13a, and the insulator film 15 described below are omitted in illustration.

The drain electrode 12 and the source electrode 13 are ohmic electrodes formed to be separated from each other on the same surface of the semiconductor substrate 11, and the drain pad electrode 12a and the source pad electrode 13a as pad electrodes for wiring are formed on the respective electrodes. The gate electrode 14 is an electrode formed at a position between the two electrodes on the semiconductor substrate 11 and forms a Schottky junction with the semiconductor substrate 11. In addition, the insulator film 15 is formed to cover the three electrodes and the surfaces of the semiconductor substrate 11 between the electrodes. The insulator film 15 is made of, for example, silicon nitride (SiN) or the like.

In addition, the stress-absorbing layer 16 is stacked at a portion just above the gate electrode 14 on the upper surface of the insulator film 15 in a shape corresponding to the shape of the upper surface of the gate electrode 14. In the embodiment, as a material of the stress-absorbing layer 16, platinum (Pt), aluminum (Al), or a metal material containing any one thereof is employed, and besides the metal material, a ceramic material such as aluminum oxide (Al₂O₃) is employed. The stress-absorbing layer 16 absorbs a stress on the gate electrode 14 which is generated when the later-described source field plate electrode 17 is arranged eccentrically at the drain electrode 12 side of the gate electrode 14, and details thereof are described later.

In addition, the source field plate electrode 17 is formed on the insulator film 15 to face the drain electrode 12 from the upper surface of the stress-absorbing layer 16. The source field plate electrode 17 is formed to extend from an area of the gate electrode 14 which is underlying the stress-absorbing layer 16 and is close to the drain electrode 12 on the upper surface of the stress-absorbing layer 16 to an area on the insulator film 15 covering the drain electrode 12 side of the stress-absorbing layer 16 and the drain electrode 12 side of the gate electrode 14 continuous thereto. In the embodiment, the width of the electrode is formed to be equal to that of the underlying gate electrode 14. In addition, a wiring layer 17a for electrically connecting the source electrode 13 is formed as a straight fine line directed from the vicinity of the center of the width of the electrode toward the source electrode 13. As a material of the source field plate electrode 17, in the embodiment, gold (Au) or an alloy containing gold (Au) is used.

In the semiconductor device 1 having the above-described configuration according to the embodiment, the source field plate electrode 17 is formed to interpose the stress-absorbing layer 16 and the insulator film 15 in the area of the drain electrode 12 side of the gate electrode 14. Since field concentration on the vicinity of the gate electrode 14 can be alleviated by the installation of the source field plate electrode 17, it is possible to improve a breakdown voltage of the semiconductor device 1. In addition, in terms of the shape, the source field plate electrode has a shape extending from the drain electrode 12 side just above the gate electrode 14 toward the drain electrode 12. In addition, since the source electrode 13 is connected by the wiring layer 17a as a straight fine line, an increase in parasitic capacitance Cgs between the gate and the source is suppressed. Therefore, in a wideband of a high-frequency range, it is possible to obtain a stable amplification characteristic with a high power.

In addition, the stress-absorbing layer 16 is formed on the upper surface of the insulator film 15 just above the gate electrode 14 in a shape corresponding to the shape of the upper surface of the gate electrode 14, and the source field plate electrode 17 is formed to be arranged eccentrically at the drain electrode 12 side on the upper surface of the stress-absorbing layer 16. Namely, the insulator film 15 and the stress-absorbing layer 16 are formed upwards from the gate electrode 14, and between the gate electrode 14 and the source field plate electrode 17. Particularly, the stress-absorbing layer 16 is stacked on the insulator film 15, and at least a portion thereof is interposed between the insulator film 15 and the source field plate electrode 17.

On the other hand, since the source field plate electrode 17 is arranged eccentrically at a position of the drain electrode 12 side in the length direction of the gate electrode 14, due to heat cycle involved with electrical conduction and the like, a stress is generated from the source field plate electrode 17 in the length direction of the gate electrode 14. In the embodiment, as described above, due to the structure where the stress-absorbing layer 16 is interposed just under the source field plate electrode 17 superimposed on the upper portion of the gate electrode 14, the stress is allowed to be absorbed by the stress-absorbing layer 16, so that it is possible to suppress a mechanical damage (crack or the like) to the gate electrode 14 and the insulator film 15 (particularly, the insulator film of the source electrode 13 side) covering the peripheral portions thereof. In addition, there is no electrical influence on a function of the source field plate electrode 17 and the parasitic capacitance Cgs between the gate and the source.

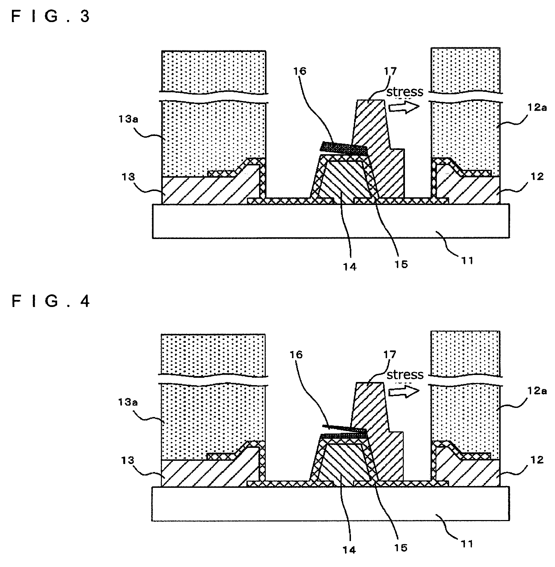

In this manner, when the stress exerted from the source field plate electrode 17 is allowed to be absorbed by the stress-absorbing layer 16, the stress-absorbing layer 16 itself is deformed in various manners. The embodiment also includes a case where, due to a difference in strength of materials between the stress-absorbing layer 16 and the peripheral portions, the stress-absorbing layer 16 undergoes damage such peeling or breakage to absorb the stress. Examples where the stress-absorbing layer 16 is damaged to absorb the stress in this manner are illustrated in Figs. 3 and 4. Fig. 3 is a diagram illustrating a model of an example where the stress-absorbing layer 16 is peeled off, and Fig. 4 is a diagram illustrating a model of an example where the stress-absorbing layer 16 is broken.

With respect to materials of peripheral components of the stress-absorbing layer 16, as described above, for example, the material of the insulator film 15 is silicon nitride (SiN), and the material of the source field plate electrode 17 is gold (Au) or an alloy containing gold (Au). Herein, in a case where the material of the stress-absorbing layer 16 is platinum (Pt), aluminum (Al), or a metal material containing any one thereof, with respect to relationship between the strengths of the materials of the insulator film 15, the stress-absorbing layer 16, and the source field plate electrode 17 and the tensile strengths of interfaces therebetween, the tensile strength of the interface between the insulator film 15 and the stress-absorbing layer 16 is smallest. Therefore, as illustrated in Fig. 3, the interface between the insulator film 15 and the stress-absorbing layer 16 is peeled off by tensile strength from the source field plate electrode 17.

In addition, in a case where the material of the stress-absorbing layer 16 is a ceramic material such as aluminum oxide (Al₂O₃), with respect to relationship between the strengths of the materials and the tensile strengths of the interfaces, the strength of the ceramic material of the stress-absorbing layer 16 is smallest. Therefore, in this case, as illustrated in Fig. 4, cracks or the like are generated in the stress-absorbing layer 16. In any case, the stress-absorbing layer 16 is damaged to absorb the stress, and thus, the stress is not exerted in the length direction of the gate electrode 14, so that it is possible to suppress a mechanical damage to the gate electrode 14 and the peripheral portions.

As described heretofore, in the embodiment, the source field plate electrode 17 is provided in the area of the drain electrode 12 side of the gate electrode 14, and the source field plate electrode 17 is connected to the source electrode 13 with the fine wiring layer 17a, so that it is possible to suppress an increase in parasitic capacitance Cgs while improving a breakdown voltage of the semiconductor device 1 and to obtain a stable high-frequency amplification characteristic with a high power. In addition, the stress-absorbing layer 16 is stacked on the upper surface of the insulator film 15 just above the gate electrode 14, and the source field plate electrode 17 is formed above the gate electrode 14 to interpose the stress-absorbing layer 16, so that the stress-absorbing layer 16 absorbs the stress exerted from the source field plate electrode 17 side in the length direction of the gate electrode 14, and thus, it is possible to suppress a mechanical damage to the gate electrode 14 and the peripheral portions thereof.

Therefore, it is possible to obtain a semiconductor device having a stable mechanical structure while maintaining a good high-frequency amplification characteristic.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope of the inventions.

## Claims

1. A semiconductor device comprising:
a semiconductor substrate;
a drain electrode and a source electrode being formed to be separated from each other on the semiconductor substrate;
a gate electrode being formed between the drain electrode and the source electrode;
an insulator film covering the drain electrode, the source electrode, the gate electrode, and at least a portion of surfaces of the semiconductor substrate between these electrodes;
a stress-absorbing layer being stacked on the insulator film covering an upper surface of the gate electrode in a shape corresponding to a shape of the upper surface of the gate electrode; and
a source field plate electrode being formed on the insulator film between the gate electrode and the drain electrode to extend from an area corresponding to the drain electrode side of the gate electrode underlying the stress-absorbing layer toward the drain electrode to cover the drain electrode side on an upper surface of the stress-absorbing layer and being electrically connected to the source electrode with a wiring layer,
wherein the stress-absorbing layer absorbs stress exerted by
in a length direction of the gate electrode.

2. The semiconductor device according to claim 1, wherein a stacked structure of the insulator film and the stress-absorbing layer exists between the gate electrode and the source field plate electrode.

3. The semiconductor device according to claim 1, wherein a tensile strength of an interface between the insulator film and the stress-absorbing layer is smaller than a strength of a material of the stress-absorbing layer and a tensile strength of an interface between the stress-absorbing layer and the source field plate electrode.

4. The semiconductor device according to claim 1, wherein a strength of a material of the stress-absorbing layer is smaller than a tensile strength of an interface between the insulator film and the stress-absorbing layer and a tensile strength of an interface between the stress-absorbing layer and the source field plate electrode.

5. The semiconductor device according to claim 3, wherein a material of the insulator film is silicon nitride, a material of the source field plate electrode is gold (Au) or an alloy containing gold (Au), and the material of the stress-absorbing layer is platinum (Pt), aluminum (Al), or a metal material containing any one thereof.

6. The semiconductor device according to claim 4, wherein a material of the insulator film is silicon nitride, a material of the source field plate electrode is gold (Au) or an alloy containing gold (Au), and the material of the stress-absorbing layer is a ceramic material.
